# EUROPEAN PATENT APPLICATION

(11) **EP 4 586 741 A1**
(43) Date of publication of application: **16.07.2025**
(21) Application number: 25151262.0
(22) Date of filing: 10.01.2025
(51) Int. Cl.: H05B 45/20

(54) **LIGHT-EMITTING DIODE MODULE**

(30) Priority: 12.01.2024 CN 202410050979
(71) Applicant: Lextar Electronics Corp., Hsinchu City 300094 (TW)
(72) Inventor: HUNG, Yu-Ping, 300094 Hsinchu City (TW); WENG, Wei-Chieh, 300094 Hsinchu City (TW); YU, Zong-Han, 300094 Hsinchu City (TW); LIU, Cheng-Yi, 300094 Hsinchu City (TW); WANG, Wen-Syun, 300094 Hsinchu City (TW)
(74) Representative: Ter Meer Steinmeister & Partner

(57) **Abstract**

A light-emitting diode module includes a casing, a lead frame, a plurality of light-emitting diodes, a control circuit, a first external power supply, a second external power supply, a first power supply pin, and a second power supply pin. The lead frame is disposed in the casing, and the lead frame has a first surface and a second surface. The second surface is opposite to the first surface. The light-emitting diodes include a first light-emitting diode, a second light-emitting diode and a third light-emitting diode, which are disposed on the first surface of the lead frame. At least one of the first light-emitting diode, the second light-emitting diode and the third light-emitting diode is electrically connected to the first external power supply through the first power supply pin, and the control circuit is electrically connected to the second external power supply through the second power supply pin.

## Description

This application claims the benefit of China Patent Application No. 2024100509797, filed January 12, 2024.

### BACKGROUND OF THE INVENTION

### Field of the Disclosure

The present disclosure relates to a light-emitting diode module, and in particular it relates to a light-emitting diode module which is connected to different external power supplies.

### Description of the Related Art

Generally speaking, a light-emitting diode with a single color or multiple colors can be installed in a light-emitting diode module, and the light-emitting diode is driven by an external power supply to emit light with a specific color. However, when multiple light-emitting diode modules are connected in series, the connected light-emitting diode modules may cause one or more light-emitting diodes to operate abnormally due to the instability of the external power supply.

### BRIEF SUMMARY OF THE INVENTION

Accordingly, one object is to provide a light-emitting diode module to solve the above problems.

It is an object to provide a light-emitting diode module being able to be operated stable.

It is an object to provide a stable power supply from an external power supply to reliable operate multiple light-emitting diode modules connected in series, wherein the one or more multiple light-emitting diode modules include one or more light-emitting diodes with a single color or multiple colors.

The object is solved by the features of the independent claims. Preferred embodiments are given in the dependent claims.

The disclosure provides a light-emitting diode module including a casing, a lead frame, a plurality of light-emitting diodes, a control circuit, a first external power supply, a second external power supply, a first power supply pin, and a second power supply pin.

The casing has a first side and a second side, and the second side is connected to the first side. The lead frame is disposed in the casing, and the lead frame has a first surface and a second surface opposite to the first surface. The plurality of light-emitting diodes includes a first light-emitting diode, a second light-emitting diode and a third light-emitting diode, which are disposed on the first surface of the lead frame. The control circuit is disposed on the second surface of the lead frame. The first power supply pin is disposed on the first side of the casing. The second power supply pin is disposed on the second side of the casing. At least one of the first light-emitting diode, the second light-emitting diode and the third light-emitting diode is electrically connected to the first external power supply through the first power supply pin, and the control circuit is electrically connected to the second external power supply through the second power supply pin.

According to some embodiments, the light-emitting diode module may further include a third power supply pin which is disposed on the second side.

According to some embodiments, the third power supply pin may be electrically independent from the first power supply pin and the second power supply pin.

According to some embodiments, the light-emitting diode module may further include a third external power supply

In one or more embodiments, the first light-emitting diode may be electrically connected to the first power supply pin.

In one or more embodiments, the second light-emitting diode and the third light-emitting diode may be electrically connected to the third external power supply through the third power supply pin.

According to some embodiments, the third external power supply may be different from the first external power supply and the second external power supply.

In one or more embodiments, the plurality of light-emitting diodes may further include a fourth light-emitting diode which is connected in series between the second light-emitting diode and the third external power supply.

According to some embodiments, the light-emitting diode module may further include a fourth power supply pin which is disposed on the second side.

In one or more embodiments, the fourth power supply pin may be electrically independent from the first power supply pin to the third power supply pin.

According to some embodiments, when viewed in a vertical direction perpendicular to the first surface, the area of the second power supply pin may be smaller than the individual area of the third power supply pin or the individual area of the fourth power supply pin.

According to some embodiments, the light-emitting diode module may further include a fourth light-emitting diode and a third external power supply.

In one or more embodiments, the fourth light-emitting diode may be connected in series between the second light-emitting diode and the third external power supply.

According to some embodiments, the third external power supply may be different from the first external power supply and the second external power supply.

According to some embodiments, the first light-emitting diode may be electrically connected to the first power supply pin.

In one or more embodiments, and the second light-emitting diode and the fourth light-emitting diode may be electrically connected to the third power supply pin.

According to some embodiments, a third voltage provided by the third external power supply to the second light-emitting diode and the fourth light-emitting diode may be greater than a first voltage provided by the first external power supply to the first light-emitting diode.

According to some embodiments, the light-emitting diode module further may include a fifth light-emitting diode and a fourth external power supply.

In one or more embodiments, the fifth light-emitting diode may be connected in series between the third light-emitting diode and the fourth external power supply.

According to some embodiments, the third light-emitting diode and the fifth light-emitting diode may be electrically connected to the fourth power supply pin.

In one or more embodiments, the fourth external power supply may be different from the first external power supply to the third external power supply.

According to some embodiments, a fourth voltage provided by the fourth external power supply to the third light-emitting diode and the fifth light-emitting diode may be greater than a first voltage provided by the first external power supply to the first light-emitting diode.

According to some embodiments, the casing may define a longitudinal axis and a transverse axis.

In one or more embodiments, the second power supply pin may have a width along the transverse axis.

In one or more embodiments, a gap between the first power supply pin and the second power supply pin may be at least greater than or equal to the width.

According to some embodiments, the first external power supply may be different from the second external power supply.

In one or more embodiments, the voltage of the first external power supply may be different from the voltage of the second external power supply.

According to some embodiments, the first external power supply and the second external power supply independently and respectively may provide currents to the plurality of light-emitting diodes and the control circuit.

The present disclosure provides a light-emitting diode module, including a casing, a lead frame, a plurality of light-emitting diodes, a control circuit, a first external power supply, a second external power supply, a first power supply pin and a second power supply pin. The lead frame is disposed in the casing, and the lead frame has a first surface and a second surface opposite to the first surface. The plurality of light-emitting diodes may include a first light-emitting diode, a second light-emitting diode and a third light-emitting diode, which are disposed on the first surface of the lead frame. The control circuit is disposed on the second surface of the lead frame.

At least one of the first light-emitting diode, the second light-emitting diode and the third light-emitting diode is electrically connected to a first external power supply through the first power supply pin, and the control circuit is electrically connected to a second external power supply through the second power supply pin. That is, this disclosure improves the lead frame of the light-emitting diode module to separate the power supply pin of the light-emitting diode and the power supply pin of the control circuit (such as the control IC chip), so that these light-emitting diodes and the control circuit are provided with power by different power sources. Therefore, based on this configuration, when the first external power supply provides a greater current to the first light-emitting diode to the third light-emitting diode, the second external power supply is not affected by the first external power supply and can provide a stable voltage (for example, stable 5 volts) to the control circuit so that the control circuit can stably control the operation of the first light-emitting diode to the third light-emitting diode.

### BRIEF DESCRIPTION OF THE DRAWINGS

Aspects of the present disclosure are best understood from the following detailed description when read with the accompanying figures. It is noted that, in accordance with the standard practice in the industry, various features are not drawn to scale. In fact, the dimensions of the various features may be arbitrarily increased or reduced for clarity of discussion.
FIG. 1 is a top schematic diagram of a light-emitting diode module 100 according to an embodiment of the present disclosure.
FIG. 2 is a bottom schematic diagram of the light-emitting diode module 100 according to an embodiment of the present disclosure.
FIG. 3 is a schematic cross-sectional view of the light-emitting diode module 100 along line A-A in FIG. 1 according to an embodiment of the present disclosure.
FIG. 4 is a functional block diagram of the light-emitting diode module 100 according to an embodiment of the present disclosure.
FIG. 5 is a top view of a light-emitting diode module 100A according to another embodiment of the present disclosure.
FIG. 6 is a functional block diagram of the light-emitting diode module 100A according to another embodiment of the present disclosure.
FIG. 7 is a top view of a light-emitting diode module 100B according to another embodiment of the present disclosure.
FIG. 8 is a functional block diagram of the light-emitting diode module 100B according to another embodiment of the present disclosure.

### DETAILED DESCRIPTION OF THE INVENTION

The following disclosure provides many different embodiments, or examples, for implementing different features of the provided subject matter. Specific examples of components and arrangements are described below to simplify the present disclosure. These are, of course, merely examples and are not intended to be limiting. For example, the formation of a first feature over or on a second feature in the description that follows may include embodiments in which the first and second features are in direct contact, and may also include embodiments in which additional features may be disposed between the first and second features, such that the first and second features may not be in direct contact.

In addition, the present disclosure may repeat reference numerals and/or letters in the various examples. This repetition is for the purpose of simplicity and clarity and does not in itself dictate a relationship between the various embodiments and/or configurations discussed. Moreover, the formation of a feature on, connected to, and/or coupled to another feature in the present disclosure that follows may include embodiments in which the features are in direct contact, and may also include embodiments in which additional features may be disposed interposing the features, such that the features may not be in direct contact. In addition, spatially relative terms, for example, "vertical," "above," "over," "below,", "bottom," etc. as well as derivatives thereof (e.g., "downwardly," "upwardly," etc.) are used in the present disclosure for ease of description of one feature's relationship to another feature. The spatially relative terms are intended to cover different orientations of the device, including the features.

Unless defined otherwise, all technical and scientific terms used herein have the same meaning as commonly understood by one of ordinary skill in the art to which this disclosure belongs. It should be appreciated that each term, which is defined in a commonly used dictionary, should be interpreted as having a meaning conforming to the relative skills and the background or the context of the present disclosure, and should not be interpreted in an idealized or overly formal manner unless defined otherwise.

Use of ordinal terms such as "first", "second", etc., in the claims to modify a claim element does not by itself connote any priority, precedence, or order of one claim element over another or the temporal order in which acts of a method are performed, but are used merely as labels to distinguish one claim element having a certain name from another element having the same name (but for use of the ordinal term) to distinguish the claim elements.

In addition, in some embodiments of the present disclosure, terms concerning attachments, coupling and the like, such as "connected" and "interconnected", refer to a relationship wherein structures are secured or attached to one another either directly or indirectly through intervening structures, as well as both movable or rigid attachments or relationships, unless expressly described otherwise.

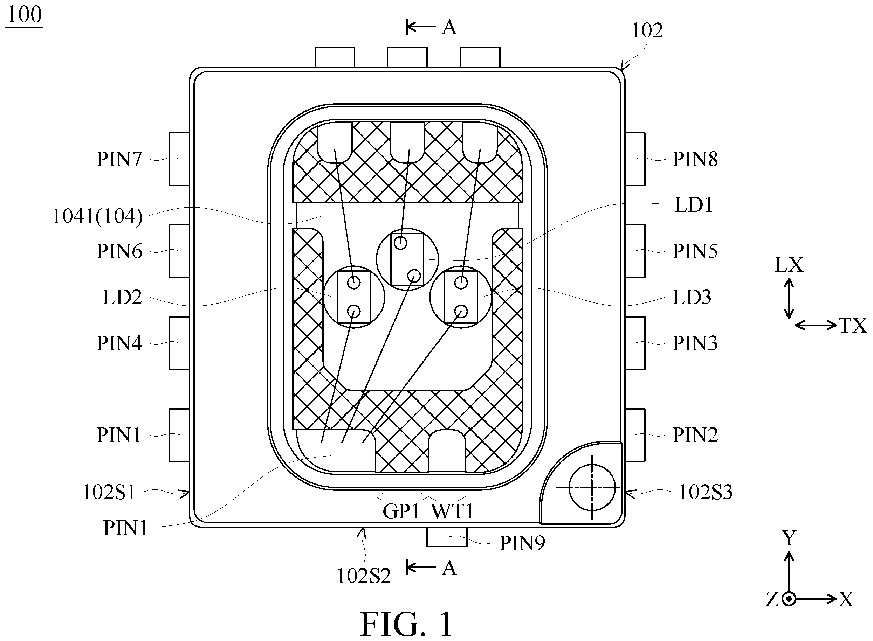

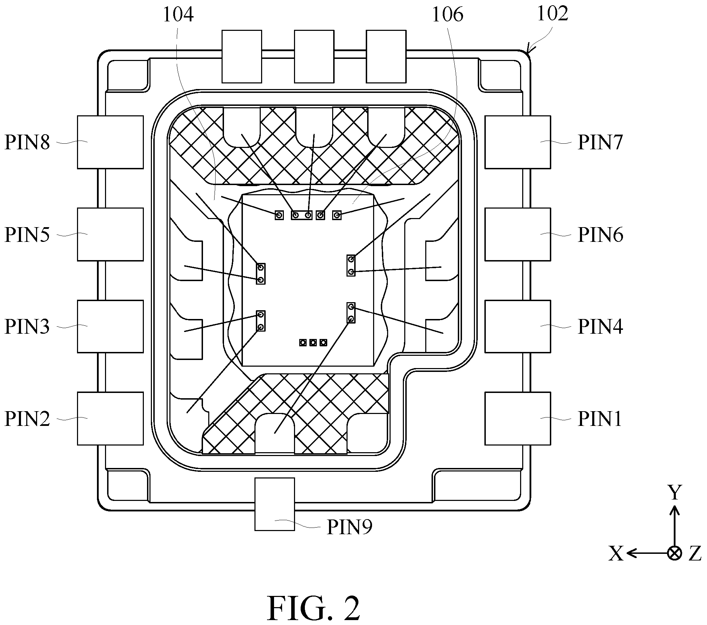

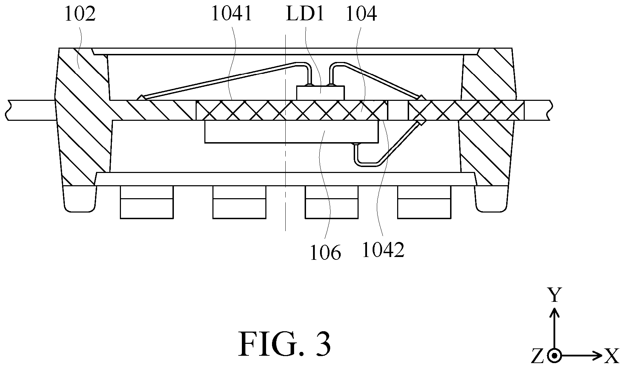

First, refer to FIG. 1 to FIG. 3. FIG. 1 is a top schematic diagram of a light-emitting diode module 100 according to an embodiment of the present disclosure, FIG. 2 is a bottom schematic diagram of the light-emitting diode module 100 according to an embodiment of the present disclosure, and FIG. 3 is a schematic cross-sectional view of the light-emitting diode module 100 along line A-A in FIG. 1 according to an embodiment of the present disclosure. In this embodiment, the light-emitting diode module 100 may include a casing 102 and a lead frame 104. The casing includes a first side 102S1, a second side 102S2 and a third side 102S3. The second side 102S2 is connected to the first side 102S1, and the third side 102S3 corresponds to the first side 102S1 and is connected to the second side 102S2. The lead frame 104 is usually made of conductive materials, such as metal or alloy materials, and the casing 102 can be a protective shell made of epoxy resin, but they are not limited thereto.

The lead frame 104 is disposed in the casing 102, and as shown in FIG. 3, the lead frame 104 has a first surface 1041 and a second surface 1042 opposite to the first surface 1041. Furthermore, the light-emitting diode module 100 further includes a plurality of light-emitting diodes, which are disposed on the lead frame 104. In this embodiment, the light-emitting diode module 100 may include a first light-emitting diode LD1, a second light-emitting diode LD2 and a third light-emitting diode LD3, which are disposed on the first surface 1041 of the lead frame 104.

In some embodiments, the light-emitting diode module 100 can provide multi-color light. For example, the first light-emitting diode LD1 emits a first color light, the second light-emitting diode LD2 emits a second color light, and the third light-emitting diode LD3 emits a third color light. The colors of the first color light, the second color light and the third color light can be different from each other. For example, the first color light is red light, the second color light is green light, and the third color light is blue light.

In addition, the light-emitting diode module 100 may further include a control circuit 106, which is integrated with the light-emitting diodes in the same casing 102 and is disposed on the second surface 1042 of the lead frame 104. The control circuit 106 can be a control IC chip, and can control the first light-emitting diode LD1, the second light-emitting diode LD2 and the third light-emitting diode LD3 to operate according to an external control signal.

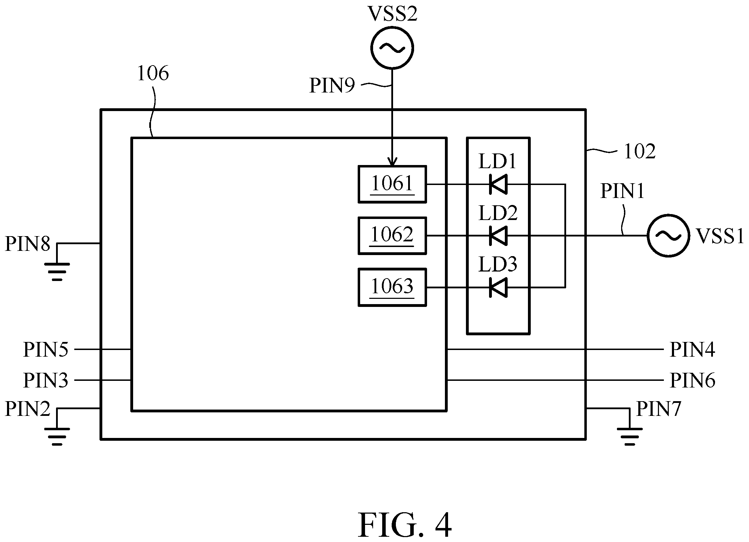

Next, refer to FIG. 1 to FIG. 4. FIG. 4 is a functional block diagram of the light-emitting diode module 100 according to an embodiment of the present disclosure. In this embodiment, the light-emitting diode module 100 may have multiple electrical pins. For example, the light-emitting diode module 100 may have first electrical pin PIN1 to ninth electrical pin PIN9.

As shown in FIG. 1, the first electrical pin PIN1 (also called the first power supply pin), the fourth electrical pin PIN4, the sixth electrical pin PIN6 and the seventh electrical pin PIN7 are disposed on the first side 102S1 of the casing 102. The ninth electrical pin PIN9 (also called the second power supply pin) is disposed on the second side 102S2 of the casing 102, and the second electrical pin PIN2, the third electrical pin PIN3, the fifth electrical pin PIN5 and the eighth electrical pin PIN8 are disposed on the third side 102S3 of the casing 102.

In this embodiment, the second electrical pin PIN2, the seventh electrical pin PIN7 and the eighth electrical pin PIN8 are used for electrical grounding, the fourth electrical pin PIN4 and the sixth electrical pin PIN6 are used for receiving the aforementioned external control signal, and the third electrical pin PIN3 and the fifth electrical pin PIN5 are used to be connected in series to another light-emitting diode module 100.

As shown in FIG. 4, the light-emitting diode module 100 further includes a first external power supply VSS1 and a second external power supply VSS2. The first electrical pin PIN1 (the first power supply pin) is electrically connected to the first external power supply VSS1, and the first light-emitting diode LD1 to the third light-emitting diode LD3 are electrically connected to the first external power supply VSS1 through the first electrical pin PIN1.

In addition, the ninth electrical pin PIN9 is electrically connected to the second external power supply VSS2, and the control circuit 106 is electrically connected to the second external power supply VSS2 through the ninth electrical pin PIN9 (the second power supply pin). It is worth noting that the first external power supply VSS1 is different from the second external power supply VSS2.

For example, the voltage of the first external power supply VSS1 is different from the voltage of the second external power supply VSS2, and the first external power supply VSS1 and the second external power supply VSS2 independently and respectively provide currents to the above-mentioned light-emitting diodes and the control circuit 106.

The light-emitting diode module 100 of the present disclosure can be applied to a variety of lighting devices, such as lighting lamps, plant lights, car lights (such as headlights or taillights, and so on), automotive interior lighting (such as car interior ambient lighting, and so on). These applications sometimes require multiple light-emitting diode modules 100 to be connected in series to form a light bar. At this time, the multiple light-emitting diodes connected in series require a greater current to drive. Based on the design of the above two independent power supplies, when the first external power supply VSS1 provides a greater current to the first light-emitting diode LD1, the second light-emitting diode LD2 and the third light-emitting diode LD3, the second external power supply VSS2 is not be affected by the first external power supply VSS1, so that the second external power supply VSS2 can provide a stable voltage (for example, a stable 5 volts) to the control circuit 106. Therefore, the control circuit 106 can stably control the first light-emitting diode LD1 to third light-emitting diode LD3 to operate.

For example, the control circuit 106 can have a first driving circuit 1061, a second driving circuit 1062 and a third driving circuit 1063, which can drive the first light-emitting diode LD1, the second light-emitting diode LD2 and the third light-emitting diode LD3 respectively. When the second external power supply VSS2 provides a stable voltage, the first driving circuit 1061 to the third driving circuit 1063 can correctly drive the first light-emitting diode LD1 to the third light-emitting diode LD3 to operate respectively (such as turning on, turning off , adjusting brightness , and so on).

In addition, as shown in FIG. 1, the casing 102 can define a longitudinal axis LX and a transverse axis TX, the ninth electrical pin PIN9 (the second power supply pin) has a width WT1 along the transverse axis TX, and a gap GP1 between the first electrical pin PIN1 (the first power supply pin) and the ninth electrical pin PIN9 is at least greater than or equal to the width WT1.

Based on the above structural configuration, the first external power supply VSS1 and the second external power supply VSS2 do not interfere with each other.

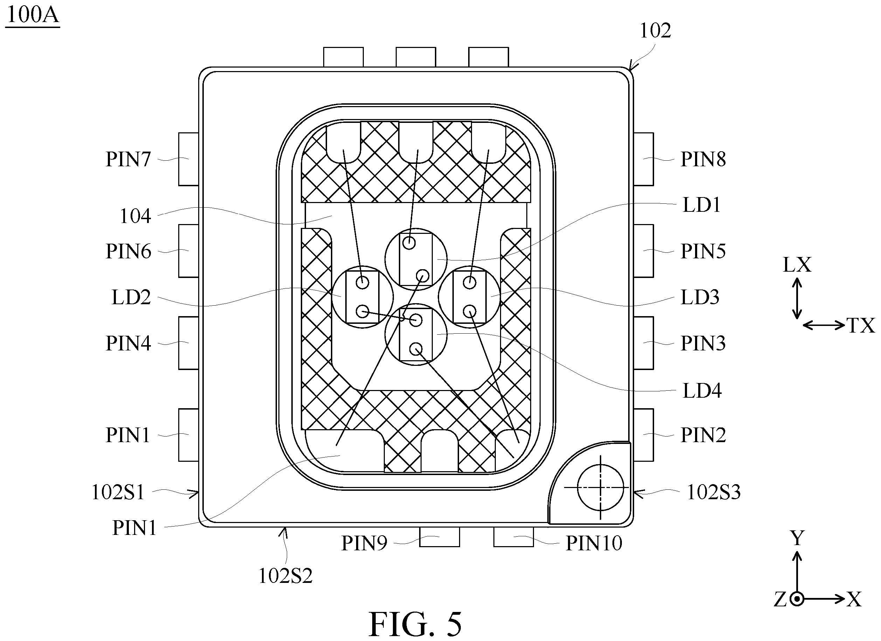

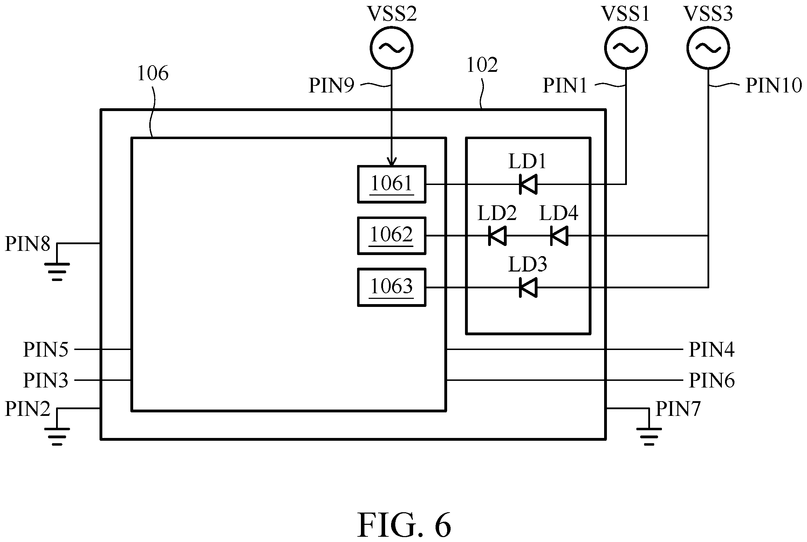

Next, refer to FIG. 5 and FIG. 6. FIG. 5 is a top view of a light-emitting diode module 100A according to another embodiment of the present disclosure, and FIG. 6 is a functional block diagram of the light-emitting diode module 100A according to another embodiment of the present disclosure. In this embodiment, the light-emitting diode module 100A may further include a third external power supply VSS3 and a tenth electrical pin PIN10 (also called the third power supply pin), and the tenth electrical pin PIN10 is disposed on the second side 102S2 of the casing 102.

The tenth electrical pin PIN10 (also called the third power supply pin) is electrically independent from the first electrical pin PIN1 (the first power supply pin) and the ninth electrical pin PIN9 (the second power supply pin).

As shown in FIG. 6, the first light-emitting diode LD1 is electrically connected to the first electrical pin PIN1 (the first power supply pin), the second light-emitting diode LD2 and the third light-emitting diode LD3 are electrically connected to the third external power supply VSS3 through the tenth electrical pin PIN10 (the third power supply pin), and the third external power supply VSS3 is different from the first external power supply VSS1 and the second external power supply VSS2, such as different voltages.

Furthermore, the light-emitting diode module 100A may further include a fourth light-emitting diode LD4, which is connected in series between the second light-emitting diode LD2 and the third external power supply VSS3.

The first light-emitting diode LD 1 is a red light-emitting diode, the second light-emitting diode LD2 and the fourth light-emitting diode LD4 are green light-emitting diodes, and the third light-emitting diode LD3 is a blue light-emitting diode. In some embodiments, the driving current required by the green light-emitting diode and the blue light-emitting diode is greater than that of the red light-emitting diode.

Therefore, based on the configuration of this embodiment, the second light-emitting diode LD2 (green light) and the fourth light-emitting diode LD4 (green light) and the third light-emitting diode LD3 (blue light) are electrically connected to the third external power supply VSS3 through the independent tenth electrical pin PIN10, which allows these light-emitting diodes to have sufficient current to operate without interfering with the operation of the first external power supply VSS1 and the first light-emitting diode LD1, so that the control of the light-emitting diodes is more precise.

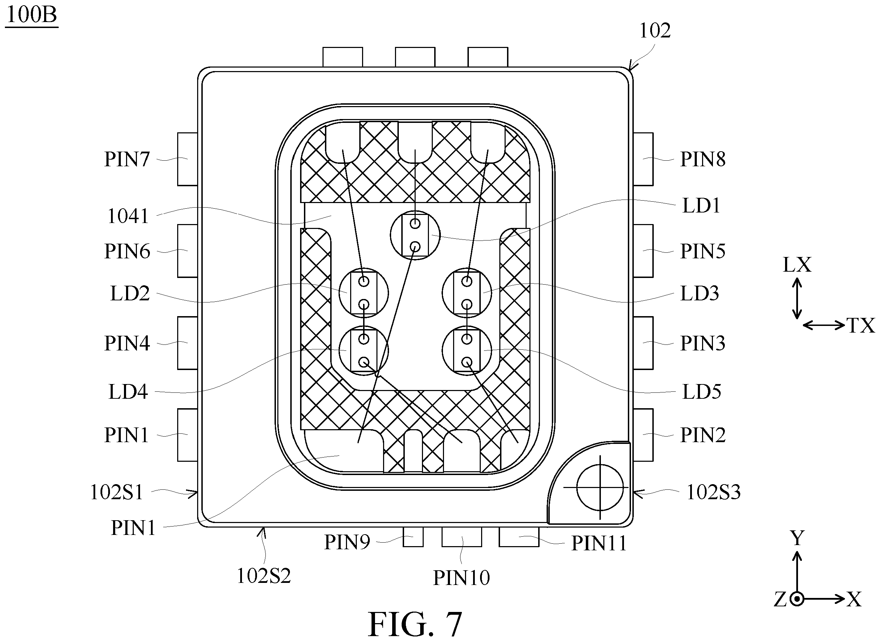

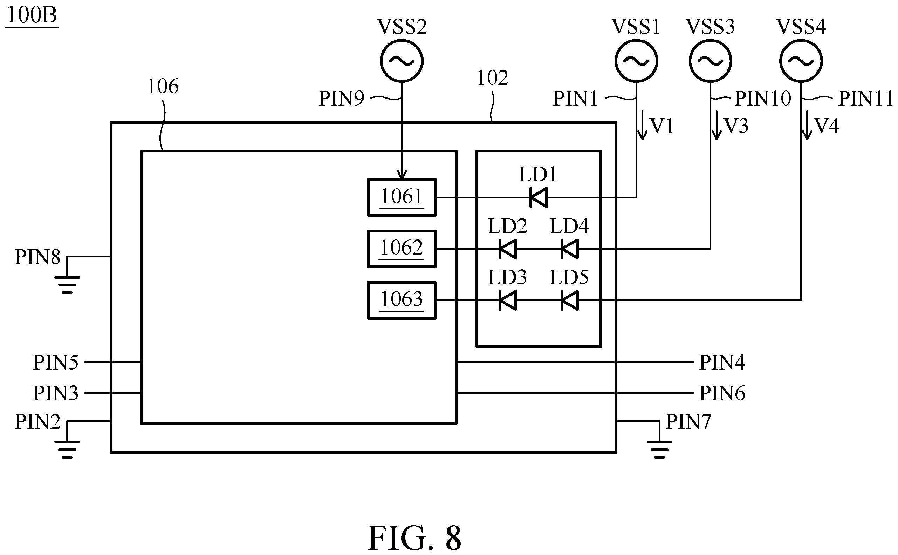

Refer to FIG. 7 and FIG. 8. FIG. 7 is a top view of a light-emitting diode module 100B according to another embodiment of the present disclosure, and FIG. 8 is a functional block diagram of the light-emitting diode module 100B according to another embodiment of the present disclosure. This embodiment is similar to the previous embodiment. The difference is that in this embodiment, the light-emitting diode module 100B further includes an eleventh electrical pin PIN11 (also called as the fourth power supply pin), which is disposed on the second side 102S2 of the casing 102, and the eleventh electrical pin PIN11 (the fourth power supply pin) is electrically independent from the first electrical pin PIN1 (the first power supply pin), the ninth electrical pin PIN9 (the second power supply pin) and the tenth electrical pin PIN10 (the third power supply pin).

In this embodiment, the light-emitting diode module 100B may further include a fourth light-emitting diode LD4, which is connected between the second light-emitting diode LD2 and the third external power supply VSS3 in series, and the third external power supply VSS3 is different from the first external power supply VSS1 and the second external power supply VSS2.

The first light-emitting diode LD1 is electrically connected to the first electrical pin PIN1 (the first power supply pin), the second light-emitting diode LD2 and the fourth light-emitting diode LD4 are electrically connected to the tenth electrical pin PIN10 (the third power supply pin). A third voltage V3 provided by the third external power supply VSS3 to the second light-emitting diode LD2 and the fourth light-emitting diode LD4 is greater than a first voltage V1 provided by the first external power supply VSS1 to the first light-emitting diode LD1.

Furthermore, as shown in FIG. 8, the light-emitting diode module 100B further includes a fifth light-emitting diode LD5 and a fourth external power supply VSS4. The fifth light-emitting diode LD5 is connected between the third light-emitting diode LD3 and the fourth external power supply VSS4 in series. The third light-emitting diode LD3 and the fifth light-emitting diode LD5 are electrically connected to the eleventh electrical pin PIN11 (the fourth power supply pin), and the fourth external power supply VSS4 is different from the first external power supply VSS1 to the third external power supply VSS3.

A fourth voltage V4 provided by the fourth external power supply VSS4 to the third light-emitting diode LD3 and the fifth light-emitting diode LD5 is greater than the first voltage V1 provided by the first external power supply VSS1 to the first light-emitting diode LD1.

Based on the above configuration, provide separate external power supplies for LEDs of different colors, which can provide different driving currents to LEDs of different colors., so that the actions of the light-emitting diodes of different colors can be more precise and they do not interfere with each other.

Because the currents that drives the second light-emitting diode LD2 that emits green light and the third light-emitting diode LD3 that emits blue light is relatively greater, in this embodiment, when viewed in a vertical direction (the Z-axis) perpendicular to the first surface 1041, the area of the ninth electrical pin PIN9 (the second power supply pin) is smaller than the individual area of the tenth electrical pin PIN10 (the third power supply pin) or the individual area of the eleventh electrical pin PIN11 (the fourth power supply pin).

Based on the above structural configuration, more electrical pins can be disposed in the limited space in the casing 102. Therefore, not only can precise control be achieved through different currents, but the casing 102 can also have the advantage of miniaturization.

In some embodiments, the first to fifth light-emitting diodes LD1∼LD5 of the present disclosure may be micro light-emitting diodes (Micro LED) or mini light-emitting diodes (Mini LED), but they are not limited thereto.

The present disclosure provides a light-emitting diode module, including a casing 102, a lead frame 104, a plurality of light-emitting diodes, a control circuit 106, a first external power supply VSS1, a second external power supply VSS2, a first power supply pin and a second power supply pin. The lead frame 104 is disposed in the casing 102, and the lead frame 104 has a first surface 1041 and a second surface 1042 opposite to the first surface 1041. The plurality of light-emitting diodes may include a first light-emitting diode LD1, a second light-emitting diode LD2 and a third light-emitting diode LD3, which are disposed on the first surface 1041 of the lead frame 104. The control circuit 106 is disposed on the second surface 1042 of the lead frame 104.

At least one of the first light-emitting diode LD1 to the third light-emitting diode LD3 is electrically connected to a first external power supply VSS1 through the first power supply pin, and the control circuit 106 is electrically connected to a second external power supply VSS2 through the second power supply pin. That is, this disclosure improves the lead frame of the light-emitting diode module to separate the power supply pin of the light-emitting diode and the power supply pin of the control circuit (such as the control IC chip), so that these light-emitting diodes and the control circuit are provided with power by different power sources. Therefore, based on this configuration, when the first external power supply VSS1 provides a greater current to the first light-emitting diode LD1 to the third light-emitting diode LD3, the second external power supply VSS2 is not affected by the first external power supply VSS1 and can provide a stable voltage (for example, stable 5 volts) to the control circuit 106 so that the control circuit 106 can stably control the operation of the first light-emitting diode LD1 to the third light-emitting diode LD3 .

Although the embodiments and their advantages have been described in detail, it should be understood that various changes, substitutions, and alterations can be made herein without departing from the scope of the embodiments as defined by the appended claims. Moreover, the scope of the present application is not intended to be limited to the particular embodiments of the process, machine, manufacture, composition of matter, means, methods, and steps described in the specification. As one of ordinary skill in the art will readily appreciate from the disclosure, processes, machines, manufacture, compositions of matter, means, methods, or steps, presently existing or later to be developed, that perform substantially the same function or achieve substantially the same result as the corresponding embodiments described herein can be utilized according to the disclosure. Accordingly, the appended claims are intended to include within their scope such processes, machines, manufacture, compositions of matter, means, methods, or steps. In addition, each claim constitutes a separate embodiment, and the combination of various claims and embodiments are within the scope of the disclosure.

## Claims

1. A light-emitting diode module, comprising:
a casing (102), having a first side (102S1) and a second side (102S2), wherein the second side (102S2) is connected to the first side (102S1);
a lead frame (104), disposed in the casing (102), wherein the lead frame (104) has a first surface (1041) and a second surface (1042) opposite to the first surface (1041);
a plurality of light-emitting diodes (LD), including a first light-emitting diode (LD1), a second light-emitting diode (LD2) and a third light-emitting diode (LD3) which are disposed on the first surface (1041) of the lead frame (104);
a control circuit (106), disposed on the second surface (1042) of the lead frame (104);
a first external power supply (VSS1);
a second external power supply (VSS2);
a first power supply pin (PIN1), disposed on the first side (102S1) of the casing (102); and
a second power supply pin (PIN2), disposed on the second side (102S2) of the casing (102);
wherein at least one of the first light-emitting diode (LD1), the second light-emitting diode (LD2) and the third light-emitting diode (LD3) is electrically connected to the first external power supply (VSS1) through the first power supply pin (PIN1), and the control circuit (106) is electrically connected to the second external power supply (VSS2) through the second power supply pin (PIN2).

2. The light-emitting diode module as claimed in claim 1, wherein the light-emitting diode module (100) further includes a third power supply pin (PIN3) which is disposed on the second side (102S2), and the third power supply pin (PIN3) is electrically independent from the first power supply pin (PIN1) and the second power supply pin (PIN2).

3. The light-emitting diode module as claimed in claim 2, wherein the light-emitting diode module (100) further includes a third external power supply (VSS3), the first light-emitting diode (LD1) is electrically connected to the first power supply pin (PIN1), and the second light-emitting diode (LD2) and the third light-emitting diode (LD3) are electrically connected to the third external power supply (VSS3) through the third power supply pin (PIN3).

4. The light-emitting diode module as claimed in claim 3, wherein the third external power supply (VSS3) is different from the first external power supply (VSS1) and the second external power supply (VSS2), and the plurality of light-emitting diodes (LD) further includes a fourth light-emitting diode (LD4) which is connected in series between the second light-emitting diode (LD2) and the third external power supply (VSS3).

5. The light-emitting diode module as claimed in claim 2, 3 or 4, wherein the light-emitting diode module (100) further includes a fourth power supply pin (PIN4) which is disposed on the second side (102S2), and the fourth power supply pin (PIN4) is electrically independent from the first power supply pin (PIN1) to the third power supply pin (PIN3).

6. The light-emitting diode module as claimed in claim 5, wherein when viewed in a vertical direction perpendicular to the first surface (102S1), an area of the second power supply pin (PIN2) is smaller than an individual area of the third power supply pin (PIN3) or an individual area of the fourth power supply pin (PIN4).

7. The light-emitting diode module as claimed in any one of the preceding claims, wherein the light-emitting diode module (100) further includes a fourth light-emitting diode (LD4) and a third external power supply (VSS3), the fourth light-emitting diode (LD4) is connected between the second light-emitting diode (LD2) and the third external power supply in series (VSS3), preferably the third external power supply (VSS3) is different from the first external power supply (VSS1) and the second external power supply (VSS2).

8. The light-emitting diode module as claimed in claim 7, wherein the first light-emitting diode (LD1) is electrically connected to the first power supply pin (PIN1), and the second light-emitting diode (LD2) and the fourth light-emitting diode (LD4) are electrically connected to the third power supply pin (PIN3).

9. The light-emitting diode module as claimed in claim 7 or 8, wherein a third voltage (V3) provided by the third external power supply (VSS3) to the second light-emitting diode (LD2) and the fourth light-emitting diode (LD4) is greater than a first voltage (V1) provided by the first external power supply (VSS1) to the first light-emitting diode (LD1).

10. The light-emitting diode module as claimed in any one of the preceding claims, wherein the light-emitting diode module (100) further includes a fifth light-emitting diode (LD5) and a fourth external power supply (VSS4), and the fifth light-emitting diode (LD5) is connected between the third light-emitting diode (LD3) and the fourth external power supply (VSS4) in series.

11. The light-emitting diode module as claimed in claim 10, wherein the third light-emitting diode (LD3) and the fifth light-emitting diode (LD5) are electrically connected to the fourth power supply pin (PIN4), and the fourth external power supply (VSS4) is different from the first external power supply (VSS1) to the third external power supply (VSS3).

12. The light-emitting diode module as claimed in claim 10 or 11, wherein a fourth voltage (V4) provided by the fourth external power supply (VSS4) to the third light-emitting diode (LD3) and the fifth light-emitting diode (LD5) is greater than the first voltage (V1) provided by the first external power supply (VSS1) to the first light-emitting diode (LD1).

13. The light-emitting diode module as claimed in any one of the preceding claims, wherein the casing (102) defines a longitudinal axis and a transverse axis, the second power supply pin (PIN2) has a width along the transverse axis, and a gap between the first power supply pin (PIN1) and the second power supply pin (PIN2) is at least greater than or equal to the width.

14. The light-emitting diode module as claimed in any one of the preceding claims, wherein the first external power supply (VSS1) is different from the second external power supply (VSS2), and the voltage of the first external power supply (VSS1) is different from the voltage of the second external power supply (VSS2).

15. The light-emitting diode module as claimed in claim 14, wherein the first external power supply (VSS1) and the second external power supply (VSS2) independently and respectively provide currents to the plurality of light-emitting diodes (LD) and the control circuit (106).
